Europäisches Patentamt

European Patent Office

Office européen des brevets

(19)

(11) Publication number: **0 409 004 A2**

# EUROPEAN PATENT APPLICATION

(21) Application number: 90112857.9

(22) Date of filing: 05.07.90

(51) Int. Cl.5: **H01L 21/58, H01L 23/13**

(30) Priority: 21.07.89 JP 189294/89

(43) Date of publication of application:
23.01.91 Bulletin 91/04

(84) Designated Contracting States:
DE FR GB

(71) Applicant: Kabushiki Kaisha Toshiba
72, Horikawa-cho Saiwai-ku
Kawasaki-shi(JP)

(72) Inventor: Yahata, Masamitsu, c/o Intellectual
Property
Division - Kabushiki K. Toshiba
1-1 Shibaura 1-chome Minato-ku Tokyo
105(JP)

(74) Representative: Lehn, Werner, Dipl.-Ing. et al
Hoffmann, Eitle & Partner Patentanwälte
Arabellastrasse 4e 4
D-8000 München 81(DE)

(54) Low-melting point glass sealed semiconductor device and method of manufacturing the same.

(57) A low-melting point glass sealed semiconductor device comprises a pair of ceramic substrates (1, 2), each of which is shaped like an arch. The ceramic substrates (1, 2) are overlaid with each other, in such a manner as to define a space (8) between them. Through this space (8), a gas generated from a thermosetting mounting agent (9) used for adhesion is guided to the outside of the semiconductor device.

FIG. 2

FIG. 3B

# LOW-MELTING POINT GLASS SEALED SEMICONDUCTOR DEVICE AND METHOD OF MANUFACTURING THE SAME

The present invention relates to a low-melting point glass sealed semiconductor device containing a semiconductor chip which is die-bonded to a ceramic substrate by use of a thermosetting mounting agent.

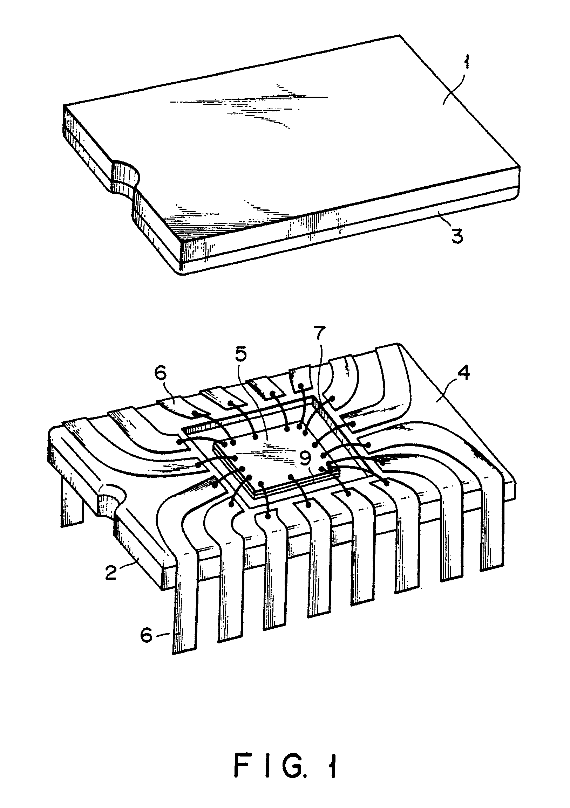

As is shown in Fig. 1, a conventional low-melting point glass sealed semiconductor device comprises: a ceramic substrate 1 coated with low-melting point glass 3 and serving as a cap; and a ceramic substrate 2 coated with low-melting point glass 4 and having a chip 5 thereon. The substrates 1 and 2 are overlaid with each other, with their glass-coated sides overlapped, and are then subjected to heat treatment. After melted by this heat treatment, the glass coated on the substrates 1 and 2 sets or hardens, thereby sealing the chip 5 on the ceramic substrate 2.

The conventional low-melting point glass sealed semiconductor device shown in Fig. 1 will be described in more detail. The semiconductor chip 5 is located on the predetermined position of the ceramic substrate 2. The semiconductor chip 5 is adhered to the ceramic substrate 2 by use of a thermosetting mounting agent (not shown). Normally, a polyimide-based agent is used as this thermosetting mounting agent, since it enables efficient work and provides reliable adhesion and since it is lower in price than gold paste. A lead frame 6 is located on low-melting point glass 4. It is electrically connected to the semiconductor chip 5 by wires 7. The ceramic substrate 1 serving as a cap is adhered to the other ceramic substrate 2. Between these ceramic substrates 1 and 2, the lead frame 6 is sandwiched and hermetically sealed. It should be noted that the thermosetting mounting agent used in the semiconductor device has a characteristic of decomposing into a gas at a high temperature.

The low-melting point glass sealed semiconductor device mentioned above is manufactured as follows. First, the ceramic substrate 2 is coated with low-melting point glass 4 in a similar manner to that in a printing process, except for the portion on which the semiconductor chip 5 is to be mounted. Next, the lead frame 6 is mounted on the low-melting point glass 4, and the chip 5 is mounted on the portion which is not coated with the glass, by use of the thermosetting mounting agent. Thereafter, the lead frame 6 and the semiconductor chip 5 are electrically connected together by wires 7. Next, the low-melting point glass 3 on ceramic substrate 2 and that 4 on ceramic substrate 3 are heated at a temperature higher than their melting points. In the state where the glass is melted, the ceramic substrates 1 and 2 are overlaid with each other and hermetically sealed.

However, the conventional semiconductor device mentioned above cannot be fabricated at high yield and is not very reliable with respect to the sealed characteristic. This is because the thermosetting mounting agent it uses is likely to decompose into a gas at a high temperature. If the thermosetting mounting agent decomposes into a gas, voids are left in the low-melting point glass 3, 4. In addition, the gas spreads along the surface of the lead frame 6, so that a tunnel-like void extending from the interior of the glass to the outside of the semiconductor device is formed, resulting in defective adhesion.

Accordingly, the first object of the present invention is to provide a low-melting point glass sealed semiconductor device, which has few voids (externally-exposed ones and internal ones) in the glass portion thereof, is reliable in both sealed characteristic and operation and yet low in price, and can be manufactured at high yield. The second object of the present invention is to provide a method of manufacturing such a semiconductor device.

To achieve the first object, the present invention provides a low-melting point glass sealed semiconductor device which comprises:

a first ceramic substrate having a rectangular shape and curved around one of two axes thereof with a predetermined curvature;

a semiconductor chip adhered to a central portion of an inwardly-curved surface of the first ceramic substrate by use of a polyimide-based thermosetting mounting agent;

a second ceramic substrate having a rectangular shape and curved around one of two axes thereof with a predetermined curvature; and

a filler member including: low-melting point glass which is coated on the inwardly-curved surface of the first ceramic substrate, except for a portion to which the semiconductor chip is adhered., and low-melting point glass which is coated on an inwardly-curved surface of the second ceramic substrate;

wherein the first and second ceramic substrates are stacked upon each other, with their inwardly-curved surfaces facing each other and with their straight side edges in contact with each other, and a space defined between the first and second ceramic substrates is filled with the filler member.

To achieve the second object, the present invention provides a method of manufacturing a low-melting point glass sealed semiconductor device, which comprises the steps of:

preparing first and second ceramic substrates each of which has a rectangular shape and is curved around one of two axes thereof with a predetermined curvature;

coating low-melting point glass on an inwardly-curved surface of the first ceramic substrate, except for a portion to which a semiconductor substrate is to be adhered;

adhering the semiconductor substrate to a central portion of the inwardly-curved surface of the first ceramic substrate by use of a polyimide-based thermosetting mounting agent;

coating low-melting point glass on an inwardly-curved surface of the second ceramic substrate;

bringing straight side edges of the first and second ceramic substrates into contact with each other, with the inwardly-curved surfaces thereof facing each other; and

gradually heating the first and second ceramic substrates, such that a gas generated from part of the thermosetting mounting agent is first guided to the outside of the device through a space defined between the curved ceramic substrates and then the low-melting point glass melted by heat fills the space and hardens.

In the low-melting point glass sealed semiconductor device of the present invention, the low-melting point glass does not contain a void arising from a gas generated by the thermosetting mounting agent. In addition, the semiconductor device does not have a tunnel-like void extending along the lead frame, i.e., a a tunnel-like void extending from the interior of the glass to the outside of the semiconductor device. Therefore, the semiconductor device is reliable in its sealed characteristic.

In the manufacturing method of the present invention, the gas produced by the decomposition of part of the thermosetting mounting agent escapes to the outside the device through the spaced defined between the first and second ceramic substrates. After the gas is completely expelled from the device, the low-melting point glass is melted, thereby filling the space and adhering the first and second ceramic substrates to each other.

This invention can be more fully understood from the following detailed description when taken in conjunction with the accompanying drawings, in which:

Fig. 1 is a perspective view of a conventional low-melting point glass sealed semiconductor device;

Fig. 2 is a perspective view of a low-melting point glass sealed semiconductor device of the present invention;

Figs. 3A to 3C illustrate the process in which the low-melting point glass sealed semiconductor device of the present invention is manufactured;

Fig. 4 is a graph showing how the temperature and weight of a thermosetting mounting agent vary in relation to heating time;

Fig. 5A is a graph showing the distribution of satisfactory and defective products in relation to the shapes of ceramic substrates; and

Figs. 5B to 5D are views illustrating curved states of ceramic substrates.

The low-melting point glass sealed semiconductor device according to one embodiment of the present invention and the manufacturing method thereof will now be described, with reference to the accompanying drawings.

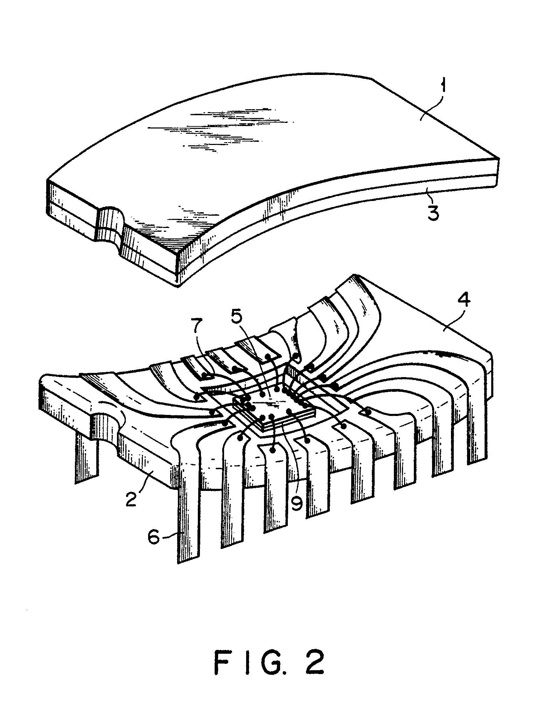

Fig. 2 is a perspective view of the low-melting point glass sealed semiconductor device according to one embodiment of the present invention.

As is shown in Fig. 2, a ceramic substrate 1 (which is used as a cap) and a ceramic substrate 2 (on which a semiconductor chip is to be installed) are both rectangular. They are curved around one of the two axes thereof with a predetermined curvature and look like arches. That is, they are warped when they have been manufactured. Low-melting point glass 3 is coated on the inwardly-curved surface of ceramic substrate 1. Likewise, low-melting point glass 4 is coated on the inwardly-curved surface of ceramic substrate 2. A semiconductor chip 5 is adhered to a predetermined portion on the inwardly-curved surface of ceramic substrate 2 by use of a thermosetting mounting agent 9. As in the prior art, this thermosetting mounting agent is a polyimide-based agent.

A lead frame 6 is attached to low-melting point glass 4. More specifically, the lead frame 6 is first placed on low-melting point glass 4, and then the resultant structure is made to pass through a furnace, so as to heat the lead frame 6 to a predetermined temperature. Accordingly, the lead frame 6 is melted and adhered to the low-melting point glass 4. Thereafter, the lead frame 6 is electrically connected to the semiconductor chip 5 by means of wires 7. After this connection, the ceramic substrate 1 serving as a cap is mounted on the ceramic substrate 2, with the inwardly-curved surfaces overlapped with each other, in such a manner as to provide a space between the two ceramic substrates. In this state, the two ceramic substrates are subjected to a bonding step, thereby obtaining the low-melting point glass sealed semiconductor device of the present invention.

The method of manufacturing the low-melting point glass sealed semiconductor device will be described, with reference to 3A through 3C.

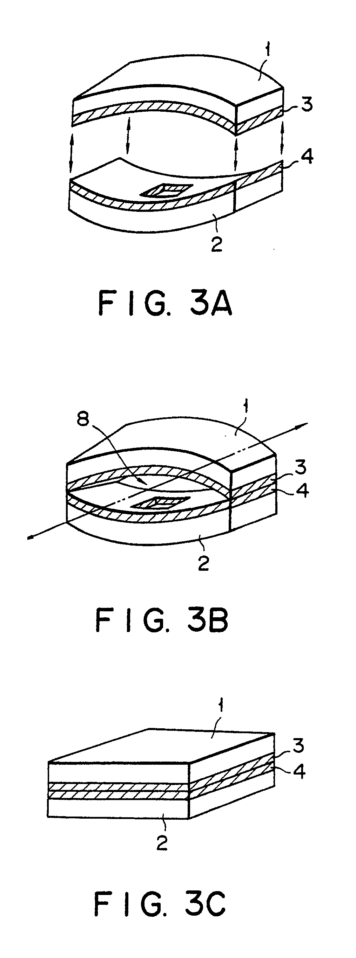

Figs. 3A to 3C are perspective views schematically illustrating the process in which the low-melting point glass sealed semiconductor device according to one embodiment of the present invention is manufactured.

First of all, two ceramic substrates 1 and 2 are prepared. As is shown in Fig. 3A, each of the ceramic substrates is rectangular in shape and is curved around one of the two axes thereof with a predetermined curvature. In the curved state, the ceramic substrates are baked. The inwardly-curved surface of ceramic substrate 1 is entirely coated with low-melting point glass 3. The inwardly-curved surface of ceramic substrate 2 is also coated with low-melting point glass 4, but this coating is performed except for the portion on which a semiconductor chip is to be mounted. These coating steps are carried out in a manner similar to that of a printing process. Next, a lead frame (not shown in Fig. 3A) is mounted on the low-melting point glass 4 of ceramic substrate 2, and in this state the substrate 2 is heated, to thereby cause the lead frame to adhere to the glass. Further, a semiconductor chip (not shown in Fig. 3A) is adhered to the installation portion on the inwardly-curved surface by use of a thermosetting mounting agent (not shown in Fig. 3A). Next, wire bonding is performed, wherein the lead frame is connected to the semiconductor chip by means of wires (not shown in Fig. 3A).

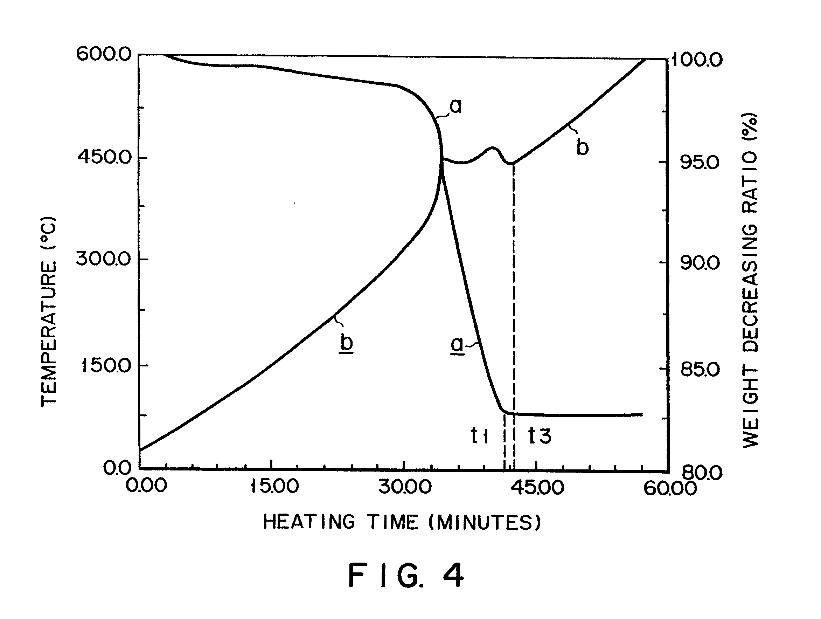

Next, an adhesion step is carried out. As is shown in Fig. 3B, the two ceramic substrates 1 and 2 are stacked upon each other in such a manner as to define a space therebetween. That is, they are stacked, with their inwardly-curved surfaces overlapped. In this state, the ceramic substrates 1 and 2 are placed in a furnace (not shown), for heating. In the initial stage of the adhesion step, the low-melting point glass 3, 4 does not melt, so that there is a space between the two substrates, as is indicated by "8" in Fig. 3B. As the thermosetting mounting agent becomes higher in temperature with time, it begins to decompose into a gas. However, this gas is discharged from the semiconductor device through the space 8 mentioned above, and does not remain inside the device. In other words, the space 8 continues to exist at temperatures at which the thermosetting mounting agent decomposes and generates a gas. This condition will be explained, referring to the graph shown in Fig. 4.

Fig. 4 is a graph showing how the temperature and weight of a thermosetting mounting agent vary in relation to heating time.

In Fig. 4, curve a represents a weight-decreasing ratio of the thermosetting mounting agent, while curve b represents a temperature increase of the thermosetting mounting agent.

How to use the graph shown in Fig. 4 will be briefly explained. At time t3, the weight-decreasing ratio of the mounting agent is about 82.5%, as is readily understood from the graph. In this case, a line segment is drawn in parallel to the ordinate from that point on curve a which corresponds to time t3 until it intersects line b. From this intersection, a line segment is drawn in parallel to the abscissa until it intersects the ordinate, and the temperature value at this intersection is read. In this way, it is understood that a weight-decreasing ration of 82.5% corresponds to a temperature of about 450°C.

As can be understood from curve a in the graph shown in Fig. 4, the weight of the mounting agent abruptly decreases at the point where the temperature exceeds 350°C. This means that the mounting agent is decomposed into a gas from this point. The decomposition of the mounting agent (i.e., the generation of a gas) continues until the point where the temperature is about 450°C, as may be understood from curve b in Fig. 4.

At 450°C, low-melting point glass 3, 4 begins to change from a solid state into a liquid state. The low-melting point glass in this transition state has a certain degree of viscosity, but can keep the shape which it has in the solid state. In other words, the space 8 between the ceramic substrates 1 and 2 is maintained in the transition state of the low-melting point glass.

As may be understood from the above, time t3 at which the low-melting point glass changes into the liquid state should be after time t1 at which the gas generation is completed. As long as this requirement is satisfied, all gas is discharged from the semiconductor device through the space 8.

After time t3, the low-melting point glass 3, 4 changes into a liquid state, thus filling the space 8 between the two ceramic substrates 1 and 2, as is shown in Fig. 3C. More specifically, the low-melting point glass 3, 4 in the fluid state flows into the space 8. After the space 8 is filled with the low-melting point glass, the heating is stopped, so as to change the low-melting point glass back into the solid state.

In the above process, the low-melting point glass sealed semiconductor device of one embodiment of the present invention is manufactured.

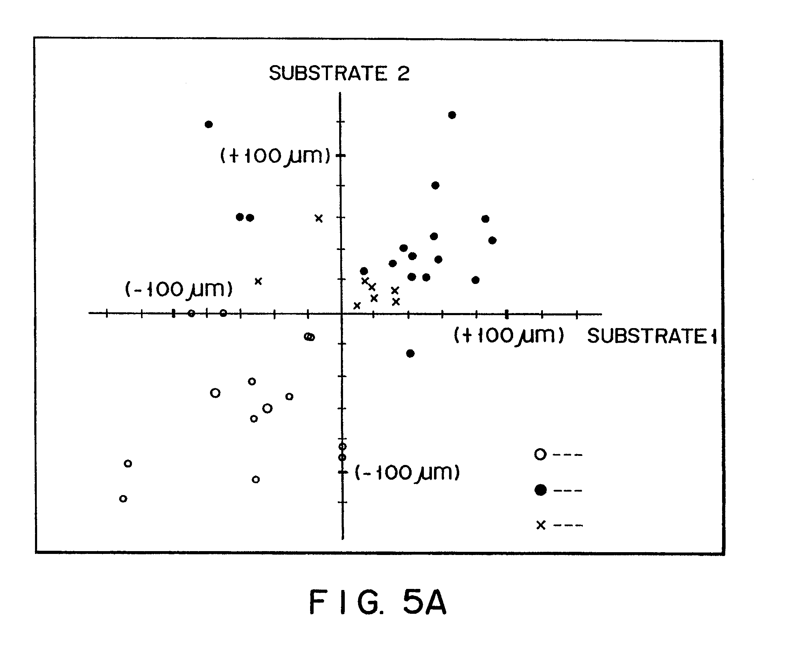

Fig. 5A is a graph showing the distribution of satisfactory and defective products, the graph being obtained by examining low-melting point glass sealed semiconductor devices whose ceramic substrates have such a shape as is determined in the present invention and by examining low-melting point glass sealed semiconductor devices whose ceramic substrates do not have such a shape as is determined in the present invention.

In Fig. 5A, the abscissa represents the maximum displacement by which the ceramic substrate 1 serving as a cap is located away from the contact plane in which substrate 1 and substrate 2 contacts each other, while the ordinate represents the maximum displacement by which the ceramic substrate 2 having a semiconductor chip thereon is located away from the same contact plane.

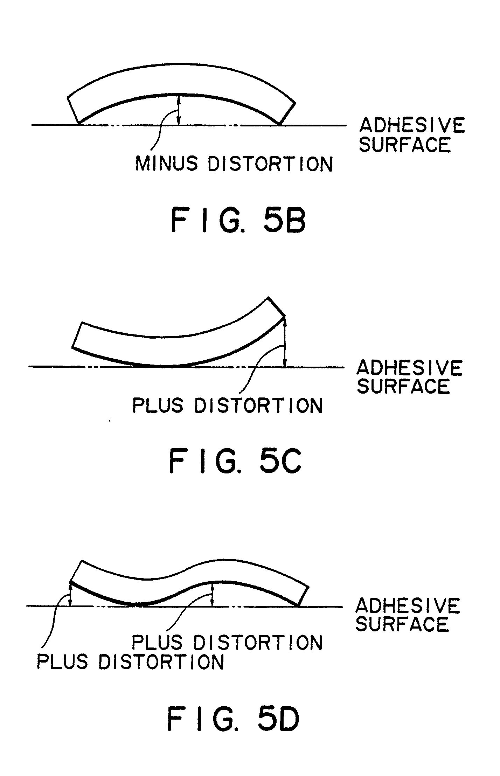

The displacements shown in Fig. 5A will be explained in more detail, with reference to the cross sectional views shown in Figs. 5B to 5D.

The ceramic substrate illustrated in Fig. 5B has such a shape as is determined in the present invention. The maximum displacement of this substrate with reference to the contact plane is represented by a negative value.

The ceramic substrate illustrated in Fig. 5C also has a shape as is determined in the present invention, but low-melting point glass is coated on the outwardly-curved surface of this substrate. Therefore, the maximum displacement of the substrate with reference to the contact plane is represented by a positive value.

The ceramic substrate illustrated in Fig. 5D is corrugated. In the case of this substrate, the displacements of points located on the glass-coated surface are represented by positive values.

Referring to Fig. 5A, all satisfactory products indicated by are in the third quadrant, where both the substrates 1 and 2 have negative displacements. As is seen in Fig. 5A, the negative displacements of the substrates 1 and 2 are concentratedly distributed in the region from 20 μm to 120 μm. The upper limit of these negative displacements is determined by the size of the low-melting point glass sealed semiconductor devices, namely, the sizes of substrates 1 and 2. For example, if the substrates 1 and 2 have a surface of approximately 52 mm × 15 mm, the upper limit of the displacements is 120 μm or so.

Defective products indicated by and × are either in the first quadrant, where both the substrates 1 and 2 have positive displacements, or in the second and fourth quadrants, where one of the substrates has a positive displacement.

Basically, the defective prooucts indicated by are a semiconductor device wherein each of the paired substrates has such a shape as is illustrated in Fig. 5C, while the defective products indicated by × are a semiconductor device wherein at least one of the paired substrates has such a shape as is illustrated in Fig. 5D.

In the low-melting point glass sealed semiconductor device of the present invention, the gas which is generated from the thermosetting mounting agent in the adhesion step hardly remains inside the device. Since the formation of voids noted above is suppressed, the semiconductor device is satisfactory in operation. Further, the method of the present invention enables such satisfactory semiconductor devices to be manufactured at high yield.

In the low-melting point glass sealed semiconductor device of the present invention, the two ceramic substrates have substantially the same shape. Therefore, the space produced when such ceramic substrates are stacked upon each other is located in the center of the semiconductor device. Thus, the formation of voids can be effectively suppressed.

As mentioned above, the low-melting point glass sealed semiconductor device of the present invention is very reliable in its sealed characteristic. In addition, the method of the present invention enables such semiconductor devices to be manufactured at high yield, thus contributing to reduction in the manufacturing cost.

Reference signs in the claims are intended for better understanding and shall not limit the scope.

## Claims

1. A low-melting point glass sealed semiconductor device, comprising:
a first ceramic substrate (2) having a rectangular shape and curved around one of two axes thereof with a predetermined curvature;
a semiconductor chip (5) adhered to a central portion of an inwardly-curved surface of the first ceramic substrate (2) by use of a polyimide-based thermosetting mounting agent (9);
a second ceramic substrate (1) having a rectangular shape and curved around one of two axes thereof with a predetermined curvature; and
a filler member (3, 4) including: low-melting point glass (4) coated on the inwardly-curved surface of the first ceramic substrate (2), except for a portion to which the semiconductor chip (5) is adhered; and low-melting point glass (3) coated on an inwardly-curved surface of the second ceramic substrate (1);
wherein the first and second ceramic substrates (1, 2) are stacked upon each other, with their inwardly-curved surfaces facing each other and with their straight side edges in contact with each other, and a space (8) defined between the first and second ceramic substrates (1, 2) is filled with the filler member (3, 4).

2. A method of manufacturing a low-melting point glass sealed semiconductor device, comprising the steps of:
preparing first and second ceramic substrates (1, 2) each of which has a rectangular shape and is curved around one of two axes thereof with a predetermined curvature;
coating low-melting point glass (4) on an inwardly-curved surface of the first ceramic substrate (2), except for a portion on which a semiconductor substrate (5) is to be adhered;
adhering the semiconductor substrate (5) to a central portion of the inwardly-curved surface of the first ceramic substrate (2) by use of a polyimide-based thermosetting mounting agent (9);

coating low-melting point glass (3) on an inwardly-curved surface of the second ceramic substrate (1);

bringing straight side edges of the first and second ceramic substrates (1, 2) into contact with each other, with the inwardly-curved surfaces coated with the low-melting point glass (3, 4) facing each other; and

gradually heating the first and second ceramic substrates (1, 2), such that a gas generated from part of the thermosetting mounting agent (9) is first guided to the outside of the device through a space (8) defined between the curved ceramic substrates (1, 2) and then the low-melting point glass (3, 4) melted by heat fills the space (8) and hardens.

F I G. 1

FIG. 2

F I G. 3A

F I G. 3B

F I G. 3C

FIG. 4

EP 0 409 004 A2

F I G. 5A

EP 0 409 004 A2

MINUS DISTORTION

ADHESIVE SURFACE

F I G. 5B

PLUS DISTORTION

ADHESIVE SURFACE

F I G. 5C

PLUS DISTORTION

PLUS DISTORTION

ADHESIVE SURFACE

F I G. 5D